Europäisches Patentamt

European Patent Office

Office européen des brevets

(19)

(11) **EP 0 463 378 B1**

(12) # EUROPEAN PATENT SPECIFICATION

(45) Date of publication and mention
of the grant of the patent:
**05.03.1997   Bulletin 1997/10**

(51) Int Cl.6: **G11C 16/06**

(21) Application number: **91108494.5**

(22) Date of filing: **24.05.1991**

(54) **An electrically-erasable, electrically-programmable read-only memory cell with a selectable threshold voltage and methods for its use**

Elektrisch löschbare, elektrisch programmierbare Festwertspeicherzelle mit wählbarer Schwellspannung und Verfahren zu ihrer Verwendung

Cellule de mémoire morte électriquement effaçable et électriquement programmable ayant une tension de seuil sélectionnable

(84) Designated Contracting States:
**DE FR GB IT NL**

(30) Priority: **29.06.1990  US 546066**

(43) Date of publication of application:
**02.01.1992   Bulletin 1992/01**

(73) Proprietor: **TEXAS INSTRUMENTS INCORPORATED**
**Dallas Texas 75265 (US)**

(72) Inventor: **Kaya, Cetin**
**Dallas, Texas 75243 (US)**

(74) Representative: **Leiser, Gottfried, Dipl.-Ing. et al**
**Prinz & Partner,**
**Manzingerweg 7**
**81241 München (DE)**

(56) References cited:
**EP-A- 0 357 503       EP-A- 0 394 705**
**EP-A- 0 398 048       EP-A- 0 421 839**
**EP-A- 0 423 833       US-A- 5 005 155**

**Description**

TECHNICAL FIELD OF THE INVENTION

The present invention relates generally to memory devices, and more particularly to electrically-erasable, electrically-programmable read-only memories with a selectable threshold voltage and methods for use of such memories.

BACKGROUND OF THE INVENTION

The most widely used electrically-erasable, electrically-programmable, read-only cell is an n-channel field effect transistor with an additional floating gate structure disposed between the channel and the control gate. By charging the floating gate with electrons, a logic "zero" can be programmed into the cell, while allowing the floating gate to remain uncharged programs a logic "one." This is due to the fact that the charge on the floating gate controls the conductance of the underlying channel area, thereby determining whether a current will be sensed between the source and the drain when reading voltages are applied therebetween.

As in the case of the conventional field effect transistor, the channel of a EEPROM cell with an uncharged floating gate (a non-programmed cell) has a threshold voltage $V_t$. This threshold voltage $V_t$ is primarily a function of the material used to form the channel and can be controlled within limits by the implantation of dopants in the channel during the fabrication of the cell. During the read operation, the control gate must be brought to a potential in excess of the threshold voltage $V_t$, as determined by the capacitive coupling between the control gate and the floating gate and floating gate and the channel, in order for current to flow between the source and the drain when a voltage potential is created between them. By charging the floating gate with electrons, however, the threshold voltage $V_t$ can be raised.

One means of effecting the charging of the floating gate is through Fowler-Nordheim tunneling. In the n-channel EEPROM, when the control gate is brought to a sufficiently high potential in relationship to the drain, electrons can be made to tunnel through a thin oxide tunneling region adjacent the drain to the floating gate, thereby charging it. By raising the threshold voltage by charging the floating gate, a logic "zero" is programmed into the cell due to the fact that the normal reading voltage applied to the control gate will not exceed the potential necessary to allow the current flow in the channel as raised by the charged floating gate, and therefore no current can be sensed when proper source and drain reading voltages are applied.

In principle, it is possible to set the threshold voltage of a EEPROM to any value by varying the amount of charge residing on the floating gate. This may be done, for instance, by varying the pulse height, duration and/or the number of pulses used in creating the voltage potential between the control gate and the drain. In practice, however, this is not an easy task. First, the threshold voltage has a logarithmic dependency on pulse duration. Further, this process is very slow, requiring unacceptable expenditures of time to program the cell to extreme values. Additionally, variations from cell to cell, especially due to differences in the tunnel oxides used for Fowler-Nordheim tunneling, create consistency problems during array operation. Finally, trapping of materials in the oxide will change the current-voltage (I-V) characteristics of the tunnel diode over time, which may require frequent calibration cycles to determine the write/erase characteristics of the EEPROM cell.

A self-limiting erase scheme for an EEPROM cell is disclosed in United States Patent No. 4,797,856. The cell includes drain and source regions formed on a substrate and separated by a channel region. An oxide layer is formed over the channel region, and a floating gate and a control gate respectively are formed over the oxide layer. Fowler-Nordheim tunneling is utilized for discharging the floating gate to erase the memory cell by causing the electrons to tunnel across the oxide layer.

This device will allow the floating gate of an EEPROM cell to be erased to a predetermined value, thus controlling the threshold voltage of the cell. This device has a major disadvantage if it is ever desired to set the threshold voltage of an unprogrammed cell. In this case, the floating gate would have to be completely charged, and then erased back to a point where the charge remaining on the floating gate set the threshold voltage of the cell to the desired value.

Thus, a need has arisen for an electrically-erasable read only memory cell in which the threshold voltage of the channel can be set either during the write cycle or the erase cycle. Such a device would be self-controlling, and would minimize the need for precise controlling of the voltage application during the write and erase cycles. Further, this device should be capable of fabrication into an integrated circuit form using conventional techniques. Finally, the device should be compatible with the peripheral devices currently used with EEPROM cells.

SUMMARY OF THE INVENTION

According to the present invention as specified in claim 1 there is provided an electrically-erasable, electrically-programmable read only memory (EEPROM) cell formed in a semiconductor layer of a first conductivity type and including circuitry for controlling the threshold voltage of the memory cell, the memory cell comprising, a first transistor formed in the semiconductor layer and having a source region and a drain region of a second conductivity type, said source and drain regions being separated by a channel region, a second transistor formed in the semiconductor layer and having a source region and a drain region of the first conductivity type, said source and drain regions being separated by a channel region, the drain region of the second transistor being connected to a ground terminal, a floating gate having a first portion insulatively adjacent the channel region of the first transistor and a second portion insulatively adjacent the channel region of the second transistor, a control gate insulatively disposed adjacent the floating gate, and characterised in that the memory cell further comprises, a tank region of the second conductivity type formed in the semiconductor layer such that it is spaced from the first transistor, the second transistor being located in the tank region, the threshold voltage control circuitry coupled to the tank region and operable to bias the tank region to a predetermined threshold potential relative to the control gate such that the cell is self-controlling, monitoring circuitry responsive to a change in potential of the source region of the second transistor to control the application of potential on the control gate such that the charge on the floating gate stops increasing when a selected threshold potential is obtained.

The present invention provides significant advantages over the prior art. A memory cell with an uncharged floating gate may have its threshold voltage set to a predetermined value without having to completely charge the floating gate and then erasing back to the desired value. The present device employs the standard voltages used during the operation of the widely used n-channel EEPROM cells. Consistency problems with attempts to adjust the threshold value by changing the characteristics of the voltage pulses used to program a memory cell are eliminated. The present cell uses structure and materials readily used in conventional EEPROM fabrication techniques. Finally, the ability to set the threshold voltage to any value within a specific range will allow the EEPROM cell to be used in various analog applications. Potential analog applications of the EEPROM cell with a write/erase mechanism to set the threshold voltage of the cell to a predetermined value include resistive ladders in a-d converters, and neural networks.

BRIEF DESCRIPTION OF THE DRAWINGS

Other advantages of the invention will be discerned when one refers to the following detailed description as taken in conjunction with the drawings, in which:

FIGURE 1 is a schematic plan view of an electrically-erasable, electrically-programmable read-only memory (EEPROM) cell with a selectable threshold voltage according to the invention;
FIGURE 2 is a greatly enlarged schematic elevational sectional view of an EEPROM cell with a selectable threshold voltage according to the invention taken substantially along line 2-2 of FIGURE 1;
FIGURE 3 is a schematic sectional view of an EEPROM cell according to the invention taken substantially along line 3-3 of FIGURE 1;
FIGURE 4 is a schematic sectional view of an EEPROM according to the invention taken substantially along line 4-4 of FIGURE 1;
FIGURE 5 is a detailed electrical schematic diagram of a first monitoring circuit portion as used in the embodiment shown in FIGURE 1;
FIGURE 6 is a detailed electrical schematic diagram of a second monitoring circuit portion as used in the embodiment shown in FIGURE 1; and
FIGURE 7 is an electrical schematic diagram of a circuit portion of an EEPROM cell according to the invention.

DETAILED DESCRIPTION OF THE INVENTION

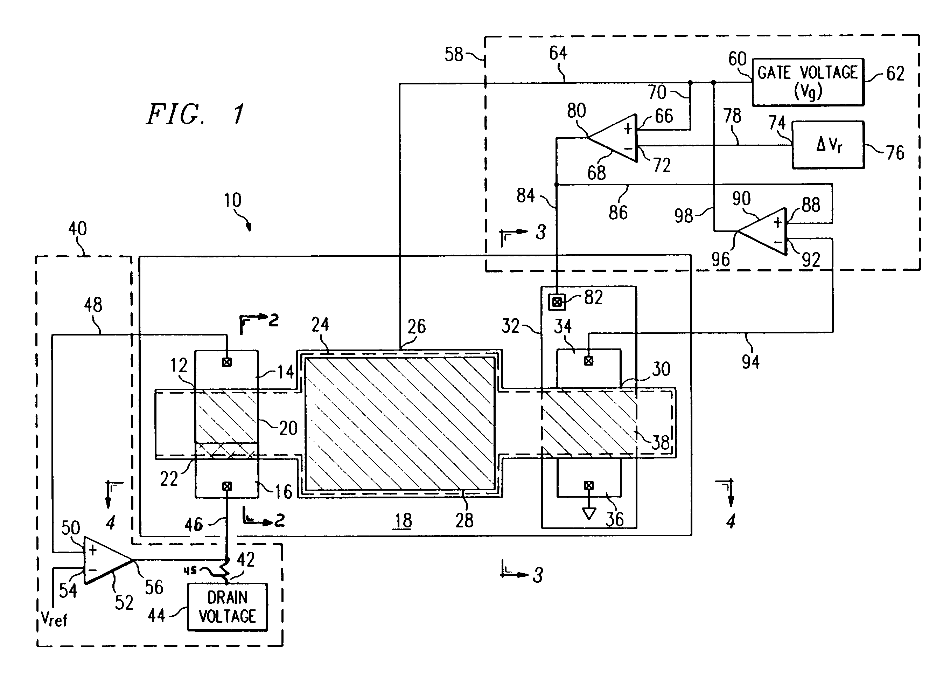

The preferred embodiment of the present invention is best understood by referring to FIGURES 1 through 7 of the drawings, like numerals being used for like and corresponding parts of the various drawings.

A plan view of an electrically-erasable, electrically-programmable read only memory cell with a controlled write/erase mechanism to set the threshold voltage to a desired value is shown generally at 10 in FIGURE 1. An n-channel EEPROM cell 12 is formed by the diffusion of an n+ source region 14 and an n+ drain region 16 into an epitaxial layer 18. Source region 14 and drain region 16 are spaced by a channel area 20 (shown by diagonal hatching from the upper left to the lower right) of epitaxial layer 18. A thin oxide tunneling window 22 (illustrated by double crosshatching) is formed overlying channel region 20 adjacent drain region 16. A floating gate 24, the outline of which is indicated by a dotted line, is insulatively disposed over channel area 20 and disposed over tunneling window 22. A control gate 26 is insulatively disposed over floating gate 24. In a preferred embodiment shown in FIGURE 1, floating gate 24 and control gate 26 extend over a thick oxide region 28 to increase the capacitive coupling area between floating gate 24 and control gate 26. (Lateral boundaries of control gate and floating gate are coextensive; shown offset only for clarity.)

A p-channel field effect transistor 30 is formed in a tank 32 of n-type material diffused into epitaxial layer 18. P-channel transistor 30 is formed by the diffusion of a p-type material into a source region 34 and a drain region 36.

Source region 34 and drain region 36 are separated by a channel region 38 of n-tank 32. Floating gate 24 extends from n-channel EEPROM cell 12 to insulatively overlie and control channel area 38 of p-channel field effect transistor 30.

A first feedback circuit is shown generally by dotted lines at 40 in FIGURE 1 for setting the threshold voltage $V_t$ of EEPROM cell 12 during an erase cycle. Output 42 of a drain voltage control circuit 44 is coupled by a contact to drain 16 of EEPROM cell 12 by a resistor 45 and a conductor 46. Source 14 of EEPROM cell 12 is coupled by a contact and conductor 48 to a non-inverting input 50 of an erase monitoring circuit 52. An inverting input 54 of erase monitoring circuit 52 is coupled to a reference voltage $V_{ref}$, while the output 56 is connected to output 42 of drain voltage control circuit 44.

A second feedback loop is shown by a dotted line generally at 58 for setting the threshold voltage of EEPROM cell 12 during a write (programming) cycle. Output 60 of gate voltage control circuitry 62 is coupled to control gate 26 by conductor 64. Output 60 of gate voltage control circuitry 62 is also connected to the non-inverting input 66 of a subtraction circuit 68 by conductor 70. The inverting input 72 of subtraction circuit 68 is connected to the output 74 of a threshold variation voltage control 76 by a conductor 78. Output 80 of subtraction circuit 68 is coupled to an n+ diffusion region 82 in tank 32 by conductor 84 and a contact. Output 80 of subtraction circuit 68 is also coupled by conductor 86 to the non-inverting input 88 of a write monitoring circuit 90. The inverting input 92 of monitoring circuit 90 is coupled by a conductor 94 and a contact to source region 34 of transistor 30. Output 96 is coupled by conductor 98 to output 60 of gate voltage control circuitry 62.

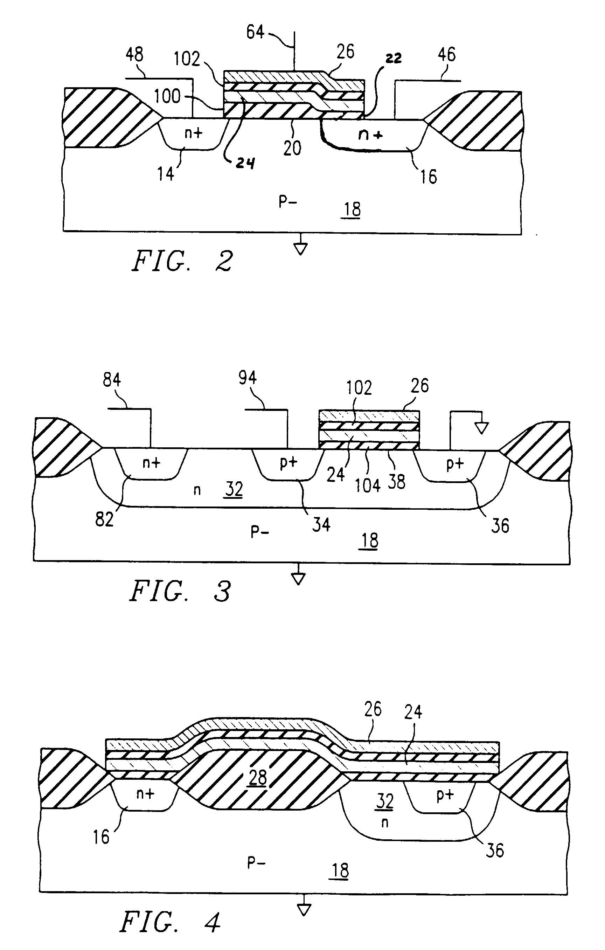

FIGURE 2 shows a schematic cross-sectional view of EEPROM cell 12 as taken substantially along line 2-2 in FIGURE 1. In FIGURE 2, floating gate 24 is separated from channel region 20 by a gate oxide 100, and is adjacent thin oxide tunneling window 22. Floating gate 24 is insulated from the overlying control gate 26 by oxide layer 102.

FIGURE 3 is a schematic cross-sectional view of field effect transistor 30 taken substantially along line 3-3 in FIGURE 1. In FIGURE 3, floating gate 24 is separated from channel region 38 by a gate oxide layer 104. Control gate 26 is separated from floating gate 24 by an oxide layer 102.

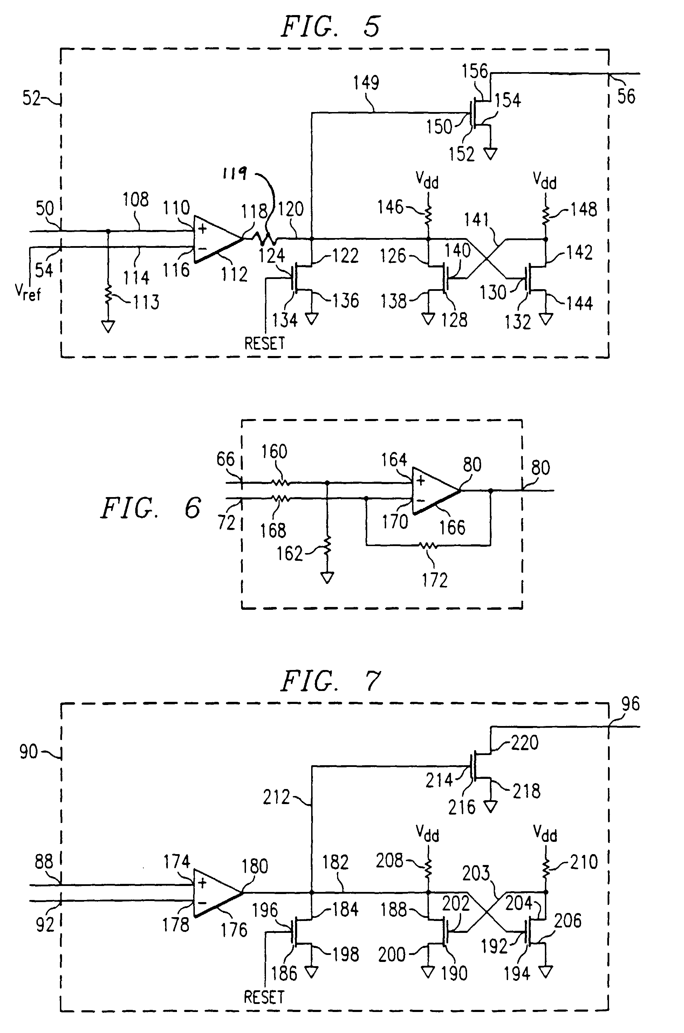

FIGURE 4 depicts a schematic sectional elevational view taken substantially along line 4-4 of FIGURE 1. FIGURE 4 depicts oxide region 28 which is grown on substrate 18 using any one of a number of conventional methods. Oxide region 28 provides additional surface area over which control gate 26 and floating gate 24 can capacitively couple, and additionally, provides electrical isolation between transistor 12 and transistor 30. Oxide region 28 can be grown as a field oxide and used as a mask to self-align the implantation of n+ source/drain regions 14 and 16. The improved capacitive coupling allows a greater portion of the voltage applied to the control gate to be coupled onto the floating gate. The voltage applied to the control gate can thereby be reduced while retaining the same ability to control channel 20.

FIGURE 5 is a schematic diagram of erase monitoring circuit 52 as shown in FIGURE 1. Input 50 is coupled by a conductor 108 to non-inverting input 110 of an operational amplifier 112. A resistor 113 provides a current path between non-inverting input 110 and ground. Input 54 is coupled by a conductor 114 to inverting input 116 of operational amplifier 112. Output 118 of operational amplifier 112 is coupled through a resistor 119 a conductor 120 to the drain 122 of transistor 124, the drain 126 of transistor 128 and the gate 130 of transistor 132.

Transistor 124 provides for resetting erase monitoring circuitry 58. The gate 134 of transistor 124 is coupled to signal RESET, while the source 136 is grounded. Transistors 128 and 132 form a latch. Source 138 of transistor 128 is grounded while the gate 140 is coupled by conductor 141 to drain 142 of transistor 132. Source 144 of transistor 132 is grounded. A resistor 146 couples drain 126 of transistor 128 and gate 130 of transistor 132 to $V_{dd}$. A resistor 148 couples gate 140 of transistor 128 and drain 142 of transistor 132 to $V_{dd}$.

Output 118 of operational amplifier 112 is additionally coupled by conductor 149 to gate 150 of output transistor 152. The source 154 of transistor 152 is grounded while the drain 156 is coupled to output 56 of erase monitoring circuitry 52. Output transistor provides a gate to selectively ground the output of drain voltage control circuitry 44, thereby controlling the voltage applied to drain 16.

FIGURE 6 depicts a preferred embodiment of the subtraction circuitry 68 shown in FIGURE 1. Input 66 is coupled to a resistor 160 which is in turn coupled to a resistor 162 to form a voltage divider between input 66 and ground. The divided voltage is then provided to the non-inverting input 164 of an operational amplifier 166. Input 72 is coupled through a resistor 168 to the non-inverting input 170 of operational amplifier 166. The output of operational amplifier 166 represents the output of subtractor circuitry 68. Resistor 172 provides feedback from output 80 to inverting input 170 of 166.

FIGURE 7 is an expanded schematic diagram of write monitoring circuitry 90 shown in FIGURE 1. Input 88 represents the non-inverting input 174 of an operational amplifier 176. Input 92 represents the inverting input 178 of operational amplifier 176. Output 180 of operational amplifier 176 is coupled by a conductor 182 to the drain 184 of a transistor 186, the drain 188 of a transistor 190 and the gate 192 of a transistor 194.

Transistor 186 provides a reset means for write monitoring circuitry 90. Gate 196 of transistor 186 is tied to a reset signal RESET. The source 198 of transistor 186 is grounded.

Transistors 190 and 194 form a latch. The source 200 of transistor 190 is grounded while the gate 202 of transistor 190 is coupled by a conductor 203 to the drain 204 of transistor 194. Source 206 of transistor 194 is grounded. Drain 188 of transistor 190 is tied to $V_{dd}$ through a pull-up resistor 208 while the drain 204 of transistor 194 is tied to $V_{dd}$ through a pull-up resistor 210.

A conductor 212 couples the output 180 of operational amplifier 176 to gate 214 of an output transistor 216. The source 218 of transistor 216 is grounded while the drain 220 provides the output 96 for write monitoring circuitry 90.

The operation of the present invention can now be described in detail using FIGURES 1, 2 and 5 for reference. For convenience, the setting of the threshold voltage will first be described in the case when EEPROM cell 12 is already programmed to a logic "0", i.e., electrons are already residing on floating gate 24. The floating gate potential $V_F$ for a single conventional nonvolatile memory cell having a floating gate can be expressed as:

Equation 1:
$$V_F = \frac{C_{pp}V_q + C_t(V_d - \phi_n) + C_d(V_d - \phi_{n'}) + C_c\phi_p + C_sV_s + Q_f}{\Sigma C_i}$$

where:

$$\Sigma C_i = C_{pp} + C_t + C_d + C_c + C_{sub} + C_s$$

$C_{pp} =$ capacitance between floating gate 24 and control gate 26;
$C_t =$ capacitance between floating gate 24 and tunnel 22;
$C_d =$ capacitance between floating gate 24 and drain 16;
$C_{sub} =$ capacitance between floating gate 24 and substrate 18;
$C_c =$ capacitance between floating gate 24 and channel 20;
$C_s =$ capacitance between floating gate 24 and source 14;
$\phi_p =$ surface potential of channel 20;
$\phi_n =$ surface potential of tunnel 22;
$\phi_{n'} =$ surface potential of drain 16;
$Q_F =$ charge on the floating gate 24;
$V_g =$ voltage applied to control gate 26;
$V_d =$ voltage applied to drain 16; and
$V_s =$ voltage applied to source 14.

the surface potential of channel 20 will be determined by the floating gate potential $V_F$.

During a standard erase operation, control gate 26 of EEPROM cell 12 would be grounded, source 14 would be allowed to float, and drain 16 would be pulsed with an erase signal of about 16 volts for about 1-100 milliseconds by drain voltage control circuitry 44. At the beginning, the surface under the floating gate 24 would be in accumulation, such that the surface potential $\phi_p$ of channel 20 and the voltage on source 14, $V_s$, will be approximately zero volts.

As electrons are pulled out of floating gate 24, via Fowler-Nordheim tunneling through tunneling window 22, the floating gate potential $V_F$ will go up. The surface of channel region 20 will gradually come out of accumulation and go into depletion. Once the floating gate potential $V_F$ is high enough to deplete the silicon, the surface potential $\phi_p$ will start to rise as will the potential of source 14 which has been allowed to float. When the increase in potential of source 14 is detected in relation to the reference voltage $V_{ref}$ by monitoring circuitry 52, the voltage applied to drain 16 may be shunted by erase monitoring circuitry 52 to ground, preventing further erase. At this point, the voltage of floating gate 24 is approximately:

$$V_F \approx \frac{C_t(V_d - \phi_n) + C_d(V_d - \phi_{n'}) + Q_F}{C_{pp} + C_F + C_d + C_{sub} + C_s + C_c} \approx 0 \qquad (2)$$

therefore, the charge on floating gate 24 is approximately:

$$Q_F = -C_t(V_d - \phi_n) - C_d(V_d - \phi n') \qquad (3)$$

The threshold voltage $V_t$ will be:

$$V_t = V_{tn} - \frac{Q_F}{C_{pp}} \qquad (4)$$

where $V_{tn}$ is the threshold voltage of the cell in a neutral (completely uncharged) state.

To erase the EEPROM cell to a different threshold voltage $V'_t$ where $V'_t$ equals $V_t + \Delta V_t$, a gate bias voltage $V_g$ can be applied during erase using gate voltage control circuitry 62, where $V_g = \Delta V_t$. When the potential on source 14 starts to rise, the floating gate potential $V'_F$ will be:

$$V'_F = \frac{C_{pp}V_q + C_t(V_d - \phi_n) + C_d(V_d - \phi_{n'}) + Q_{F'}}{C_{pp} + C_t + C_d + C_{sub} + C_{s+C_c}} \qquad (5)$$

Therefore, the charge on floating gate 24 will now become:

$$Q_{F'} = -C_t(V_d - \phi_n) + C_d(V_d - \phi_{n'}) - C_{pp}V_g \qquad (6)$$

or:

$$Q_{F'} = Q_F = C_{pp}V_g \qquad (7)$$

The threshold voltage $V_{t'}$ will become:

$$V_{t'} = V_{tn} - \frac{Q_{F'}}{C_{pp}} = V_{tn} - \frac{Q_F}{C_{pp}} + V_g \qquad (8)$$

or:

$$V_{t'} = V_t + V_g = V_t + \Delta V_t \qquad (9)$$

Thus, equation 10 shows that an EEPROM cell can be erased to any threshold voltage $V_t$, by applying an appropriate gate bias approximating the desired increase in threshold voltage $\Delta V_t$ to control gate 26 during the erase operation, using gate voltage control circuitry 62. When the potential source 14 beings to rise, monitoring circuitry 52 halts the application of voltage to drain 16, stopping erase with floating gate 24 partially charged, thereby leaving the threshold voltage at $V_t'$.

The main disadvantages of setting the threshold voltage during the erase cycle are slow speed and increased costs. When a positive gate bias is used the erase operation is slowed considerably. This speed disadvantage can be overcome by using a negative gate bias, however, generating the required negative voltages on the chip is significantly expensive.

The disadvantages of setting the threshold voltage of EEPROM cell 12 during the erase operation can be overcome by setting the threshold voltage during the write (programming) cycle. In this instance, transistor 30 operates cooperatively with EEPROM cell 12. In this case, during the write operation, while the floating gate 24 is being charged with electrons, the potential on floating gate 24 will be:

$$V_F = \frac{C_{pp}V_q + C_{NT}(V_{TANK}) + Q_F}{\Sigma C_i + C_{NT}} \qquad (10)$$

where,

$C_{NT} =$ capacitance between floating gate 24 and tank 32;
$V_{TANK} =$ potential of tank 32.

When the potential of source 34 goes down as the floating gate 24 becomes charged:

$$V_F \approx V_{TANK} \approx \frac{C_{pp}V_q + C_{NT}(V_{TANK})\,Q_f}{\Sigma\,C_i + C_{NT}} \tag{11}$$

therefore, the charge on the floating gate 24 becomes:

$$Q_F = V_{TANK}\,\Sigma C_i - V_g C_{pp} \tag{12}$$

The threshold voltage can now be represented as:

$$V_t = V_{tN} - \frac{Q_f}{C_{pp}} = V_{tN} - \frac{V_{TANK}\,\Sigma C_i}{C_{pp}} + V_g \tag{13}$$

where $V_{tN}$ is the threshold voltage of p-channel 38.

If the coupling of control gate 26 and floating gate 24 is improved by increasing the coupling area over oxide layer 28, then $C_{pp} \approx \Sigma C_i$. The threshold voltage becomes:

$$V_t \approx C_{tN} - V_{TANK} + V_g \tag{14}$$

If the voltage on tank 32 approximates the difference between the control gate voltage $V_g$ and the desired change in threshold voltage $\Delta V_t$, i.e. $V_{TANK} \approx V_g - \Delta V_t$, then:

$$V_t \approx V_{tN} + \Delta V_t \tag{15}$$

Thus, by properly biasing the n-tank 32 of transistor 30 with respect to control gate 26, the threshold voltage of EEPROM cell 12 can be set as follows during the write cycle.

Drain 16 of EEPROM cell 12 is grounded, while the source 14 is allowed to float. A high voltage of approximately 17 volts is applied to control gate 26, creating a high voltage differential between control gate 26 and drain 16. The voltage differential allows electrons to tunnel from drain 16 to floating gate 24 through tunneling window 22. As the electrons begin to reside on floating gate 24, the potential of floating gate 24 begins to go down.

Tank 32 of field transistor 30 has been biased to a voltage equal to the control gate voltage less the desired change in threshold voltage ($V_g - \Delta V_t$) through the application of gate voltage $V_g$ by gate voltage control circuitry 62 and a threshold variation voltage $\Delta V_t$ by threshold variation circuitry 76 to subtraction circuit 68. Drain 34 of field effect transistor 30 has been grounded while source 36 has been allowed to float. Since transistor 30 is a p-channel device, while the potential of floating gate 24 remains sufficiently positive, i.e., the potential of the floating gate remains above the threshold voltage of the field effect transistor 30 as biased by the application of the bias voltage to tank 32, there is no conductance between drain 34 and source 36. When, however, a sufficient number of electrons have tunneled on to floating gate 24 and the potential of floating gate 24 has gone sufficiently negative, field effect transistor 30 turns on and a conductance path is created between drain 34 and source 36. Source 36 is thus clamped to the voltage on drain 34, which in this case is ground. When monitor circuit 90 detects the decrease in the potential on source 36 in relation to the voltage $V_g - V_t$ applied to tank 32, it shunts output 60 of gate voltage control circuitry 62 to ground, such that no voltage is applied to control gate 26. The charging of floating gate 24 is stopped at that point, effectively setting the threshold voltage of EEPROM cell 12 to a voltage proportionate to the amount of charge already allowed to tunnel to floating gate 24.

The threshold voltage of EEPROM cell 12 can thus be set to any value within the range defined by the threshold voltage when floating gate 24 is not charged, and a voltage proportionate to the maximum charge which can be accumulated on floating gate 24. The disadvantages of setting the threshold voltage during the erase cycle are thereby eliminated. Further, in the present invention, the threshold voltage may optionally be applied during the erase or the write cycle, such that the user may start the operation of setting the threshold with either a charged or uncharged floating gate.

Although the present invention has been described in detail, it should be understood that various changes, substitutions and alterations can be made herein without departing from the scope of the invention as defined by the appended claims.

**Claims**

1. An electrically-erasable, electrically-programmable read only memory (EEPROM) cell (10) formed in a semiconductor layer of a first conductivity type and including circuitry (76) for controlling the threshold voltage of the memory cell (10), the memory cell (10) comprising;

a first transistor (12) formed in the semiconductor layer and having a source region (14) and a drain region (16) of a second conductivity type, said source and drain regions (14, 16) being separated by a channel region (20);
a second transistor (30) formed in the semiconductor layer and having a source region (34) and a drain region (36) of the first conductivity type, said source and drain regions (34, 36) being separated by a channel region (38), the drain region (36) of the second transistor (30) being connected to a ground terminal;
a floating gate (24) having a first portion insulatively adjacent the channel region (20) of the first transistor (12) and a second portion insulatively adjacent the channel region (38) of the second transistor (30);
a control gate (26) insulatively disposed adjacent the floating gate (24); and

characterized in that the memory cell (10) further comprises;

a tank region (32) of the second conductivity type formed in the semiconductor layer such that it is spaced from the first transistor (12), the second transistor (30) being located in the tank region (32);
the threshold control circuitry (76) coupled to the tank region (32) and operable to bias the tank region (32) to a predetermined threshold potential relative to the control gate (26) such that the cell (10) is self-controlling, monitoring circuitry (58) responsive to a change in potential of the source region (34) of the second transistor (30) to control the application of potential on the control gate (26) such that the charge on the floating gate (24) stops increasing when a selected threshold potential is obtained.

2. The memory cell according to claim 1, wherein the memory cell (10) includes circuitry operable during an erase cycle to control the discharge of the floating gate comprising:

a drain voltage control circuit (44) operable to apply a potential to the drain region (16) of the first transistor (12);
an erase monitor circuit (52) for monitoring the potential of the source region (14) of the first transistor (12), the first monitoring circuit (52) being responsive to a change in the potential of the source region (14) of the first transistor to halt the application of potential by drain voltage control circuitry (42) to the drain region (16) of the first transistor (12).

3. The memory cell according to claim 2, further comprising;

gate voltage control circuitry (62) operable to apply a potential to the control gate (26); and
wherein the monitoring circuit (58) is coupled to the gate voltage control circuitry (62) for monitoring the potential of the source region (34) of the second transistor (30) relative to the tank region (32), the monitoring circuit (58) being responsive to a change in potential of the source region (34) relative to the control gate (26) to halt the application of potential to the control gate (26) by the gate voltage control circuitry (62).

4. The memory cell according to claims 1-3, wherein the drain region (16) and the source region (14) of the first transistor (12) are formed from an n-type material, and the drain region (36) and source region (34) of the second transistor (30) are formed from a p-type material.

5. The memory cell according to any preceding claim further comprising;
a thick oxide region formed such that it separates the first transistor (12) and the second transistor (30).

6. The memory cell according to any preceding claim further comprising;
a thin oxide tunneling window (22) formed overlying the channel region (20) of the first transistor (12) and adjacent the drain region (16) thereof.

7. The memory cell according to claim 6, wherein the window (22) is a Fowler-Nordheim tunneling window.

8. The memory cell according to claim 7, wherein the control gate (26) is operable to charge and discharge the floating gate (24) by Fowler-Nordheim tunneling through said tunneling window (22) upon application of a predetermined potential to the control gate (26) and to the drain region (16) of the first transistor (12).

9. The memory cell according to any preceding claim, wherein the floating gate (24) has a third portion having a relatively large surface area which capacitively couples with a co-extensive portion of the control gate (26).

10. The memory cell according to claims 5 to 9, wherein the control gate (26) and the floating gate (24) are coupled in a region substantially overlying the thick oxide region.

11. The memory cell according to any preceding claim, wherein said monitoring circuit (58) comprises a differential amplifier circuit (90) which is operable to measure the potential difference between the tank region (32) and the source region (34) of the second transistor (30).

12. The memory cell according to any preceding claim, wherein the threshold control circuitry (76) is operable to bias the tank region (32) to a potential equal to the control gate (26) potential less a pre-determined change in the threshold potential of the memory cell (10).

13. The memory cell according to any preceding claim further comprising;
means coupled to the floating gate (24) for incrementally increasing charge stored on the floating gate (24) until a first predetermined threshold potential is achieved.

14. The memory cell according to any preceding claim further comprising;
means coupled to the floating gate (24) for incrementally decreasing charge stored on the floating gate (24) until a second predetermined threshold potential is achieved.

15. The memory cell according to any preceding claim, wherein the monitoring circuitry (58) is adapted to differentially detect the difference between said tank region (32) and the source region (34) of the second transistor (30).

16. A method for setting threshold voltage of an electrically-erasable, electrically-programmable read only memory cell (10) including a first transistor (12) having a source (14) and a drain (16) separated by an n-channel (20), a floating gate (24) insulatively overlying the channel (20), a tunneling window (22) disposed in the channel (20) adjacent the drain (16), and a control gate (26) insulatively overlying the floating gate (24), and a second transistor (30) having a source (34) and drain (36) separated by a p-channel (38), the n-channel (20) being controlled by the floating gate (24) of the first transistor (12), comprising the steps of:

applying a drain write voltage to the drain (16) of the first transistor (12);
applying a control gate write voltage to the control gate (26) of the first transistor (12);
responsive to said steps applying write voltages, causing electrons to flow from the drain (16) of the first transistor (12) to the floating gate (24) via Fowler-Nordheim tunneling;
grounding the drain (36) of the second transistor (30);
allowing the source (34) of the second transistor (30) to float;
biasing the channel (38) of the second transistor (30) to preselect the threshold voltage;
monitoring the potential of the source (34) of the second transistor (30); and
in response to said step of monitoring, halting the application of the write voltage to the control gate (26) of the first transistor (12) when the voltage on the source (34) of the second transistor (12) decreases.

17. The method of claim 16, wherein said step of biasing the channel (38) of the second transistor (30) comprises the application of a positive voltage to increase the threshold voltage of the cell.

18. The method of claim 17, wherein the positive voltage is applied to a tank (32) formed in a substrate and in which the second transistor (30) is formed.

19. The method of claim 18, wherein the voltage applied to the tank (32) is equal to the gate write voltage less the desired change in threshold voltage of the cell (10).

**Patentansprüche**

1. Elektrisch löschbare, elektrisch programmierbare Festwertspeicherzelle (EEPROM-Zelle), die in einer Halbleiterschicht eines ersten Leitfähigkeitstyps gebildet ist und Schaltungsanordnungen zur Steuerung der Schwellenspannung der Speicherzelle (10) enthält, wobei die Speicherzelle (10) umfaßt:

   einen ersten in der Halbleiterschicht gebildeten Transistor (12) mit einem Sourcebereich (14) und einem Drainbereich (16) eines zweiten Leitfähigkeitstyps, wobei der Sourcebereich (14) und der Drainbereich (16) durch einen Kanalbereich (20) getrennt sind;
   einen zweiten in der Halbleiterschicht gebildeten Transistor (30) mit einem Sourcebereich (34) und einem Drainbereich (36) des ersten Leitfähigkeitstyps, wobei der Sourcebereich (34) und der Drainbereich (36) durch einen Kanalbereich (38) getrennt sind und der Drainbereich (36) des zweiten Transistors (30) mit einem Masseanschluß verbunden ist;
   ein Floating-Gate (24) mit einem ersten Abschnitt, der isoliert vom Kanalbereich (20) des ersten Transistors (12) diesem Kanalbereich (20) des ersten Transistors (12) benachbart ist, und einem zweiten Abschnitt, der isoliert vom Kanalbereich (38) des zweiten Transistors (30) diesem Kanalbereich (38) des zweiten Transistors (30) benachbart ist;
   ein Steuergate (26), das isoliert von dem Floating-Gate (24) diesem Floating-Gate (24) benachbart angeordnet ist;

   dadurch gekennzeichnet, daß die Speicherzelle (10) darüber hinaus umfaßt:

   einen Wannenbereich (32) des zweiten Leitfähigkeitstyps, der so in der Halbleiterschicht gebildet ist, daß er in Abstand zum ersten Transistor (12) angeordnet ist, wobei der zweite Transistor (30) sich in dem Wannenbereich (32) befindet;
   die Schwellenspannungssteuerschaltungsanordnung (76), die mit dem Wannenbereich (32) verbunden ist und so betrieben werden kann, daß an den Wannenbereich (32) eine Vorspannung bis zu einem vorbestimmten Schwellenpotential relativ zum Steuergate (26) angelegt wird, so daß die Zelle (10) selbststeuernd ist, eine Überwachungsschaltungsanordnung (58), die auf eine Änderung des Potentials des Sourcebereichs (34) des zweiten Transistors (30) reagiert, um das Anlegen eines Potentials an das Steuergate (26) so zu steuern, daß die Ladung auf dem Floating-Gate (24) aufhört zuzunehmen, wenn ein ausgewähltes Schwellenpotential erreicht ist.

2. Speicherzelle nach Anspruch 1, bei der die Speicherzelle (10) eine Schaltungsanordnung enthält, die während eines Löschzyklus so betrieben werden kann, daß sie die Entladung des Floating-Gates steuert, wobei die Schaltungsanordnung umfaßt:

   eine Drainspannungssteuerschaltung (44), die so betrieben werden kann, daß ein Potential an den Drainbereich (16) des ersten Transistors (12) angelegt wird;
   eine Löschüberwachungsschaltung (52) zum Überwachen des Potentials des Sourcebereichs (14) des ersten Transistors (12), wobei die erste Überwachungsschaltung (52) auf eine Änderung des Potentials des Sourcebereichs (14) des ersten Transistors so reagiert, daß das Anlegen des Potentials durch die Drainspannungssteuerschaltungsanordnung (42) an den Drainbereich (16) des ersten Transistors (12) gestoppt wird.

3. Speicherzelle nach Anspruch 2, darüber hinaus umfassend:

   eine Gatespannungssteuerschaltungsanordnung (62), die so betrieben werden kann, daß ein Potential an das Steuergate (26) angelegt wird; und
   bei der die Überwachungsschaltung (58) mit der Gatespannungssteuerschaltungsanordnung (62) verbunden ist, um das Potential des Sourcebereichs (34) des zweiten Transistors (30) relativ zum Wannenbereich (32) zu überwachen, wobei die Überwachungsschaltung (58) auf eine Änderung des Potentials des Sourcebereichs (34) relativ zum Steuergate (26) so reagiert, daß das Anlegen des Potentials an das Steuergate (26) durch die Gatespannungssteuerschaltungsanordnung (62) gestoppt wird.

4. Speicherzelle nach einem der Ansprüche 1 bis 3, bei der der Drainbereich (16) und der Sourcebereich (14) des ersten Transistors (12) aus Material vom N-Typ gebildet sind und der Drainbereich (36) und der Sourcebereich (34) des zweiten Transistors aus Material vom P-Typ gebildet sind.

5. Speicherzelle nach einem der vorhergehenden Ansprüche, darüber hinaus umfassend:
einen Dickoxidbereich, der so gebildet ist, daß er den ersten Transistor (12) und den zweiten Transistor (30) trennt.

6. Speicherzelle nach einem der vorhergehenden Ansprüche, darüber hinaus umfassend:
ein Dünnoxid-Tunnelfenster (22), das über dem Kanalbereich (20) des ersten Transistors (12) und an den Drainbereich (16) des ersten Transistors (12) angrenzend gebildet ist.

7. Speicherzelle nach Anspruch 6, bei der das Fenster (22) ein Fenster für Fowler-Nordheim-Tunnelung ist.

8. Speicherzelle nach Anspruch 7, bei der das Steuergate (26) so betrieben werden kann, daß das Floating-Gate (24) beim Anlegen eines vorbestimmten Potentials an das Steuergate (26) und den Drainbereich (16) des ersten Transistors (12) durch Fowler-Nordheim-Tunnelung über das Tunnelfenster (22) geladen und entladen wird.

9. Speicherzelle nach einem der vorhergehenden Ansprüche, bei der das Floating-Gate (24) einen dritten Abschnitt mit einer relativ großen Oberfläche aufweist, der mit einem sich in gleicher Weise erstreckenden Abschnitt des Steuergates (26) kapazitiv koppelt.

10. Speicherzelle einem der Ansprüche 5 bis 9, bei der das Steuergate (26) und das Floating-Gate (24) in einem Bereich gekoppelt sind, der im wesentlichen über dem Dickoxidbereich liegt.

11. Speicherzelle nach einem der vorhergehenden Ansprüche, bei der die Überwachungsschaltung (58) eine Differenzverstärkerschaltung (90) umfaßt, die so betrieben werden kann, daß sie die Potentialdifferenz zwischen dem Wannenbereich (32) und dem Sourcebereich (34) des zweiten Transistors (30) mißt.

12. Speicherzelle nach einem der vorhergehenden Ansprüche, bei der die Schwellensteuerschaltungsanordnung (76) so betrieben werden kann, daß an den Wannenbereich (32) eine Vorspannung bis zu einem Potential angelegt wird, daß dem Potential des Steuergates (26) minus einer vorbestimmten Änderung des Schwellenpotentials der Speicherzelle (10) entspricht.

13. Speicherzelle nach einem der vorhergehenden Ansprüche, darüber hinaus umfassend:
Mittel, die mit dem Floating-Gate (24) verbunden sind, um die auf dem Floating-Gate (24) gespeicherte Ladung schrittweise zu erhöhen, bis ein erstes vorbestimmtes Schwellenpotential erreicht ist.

14. Speicherzelle nach einem der vorhergehenden Ansprüche, darüber hinaus umfassend:
Mittel, die mit dem Floating-Gate (24) verbunden sind, um die auf dem Floating-Gate (24) gespeicherte Ladung schrittweise zu vermindern, bis ein zweites vorbestimmtes Schwellenpotential erreicht ist.

15. Speicherzelle nach einem der vorhergehenden Ansprüche, bei der die Überwachungsschaltungsanordnung (58) in differentieller Weise den Unterschied zwischen dem Wannenbereich (32) und dem Sourcebereich (34) des zweiten Transistors (30) erfassen kann.

16. Verfahren zum Einstellen der Schwellenspannung einer elektrisch löschbaren, elektrisch programmierbaren Festwertspeicher-Zelle (10), die einen ersten Transistor (12) mit einem Sourcebereich (14) und einem von diesem Sourcebereich (14) durch einen N-Kanal (20) getrennten Drainbereich (16), einem von dem Kanal (20) isolierten und über dem Kanal (20) liegenden Floating-Gate (20), einem in dem Kanal (20) angrenzend an den Drainbereich (16) angeordneten Tunnelfenster (22) und einem von dem Floating-Gate (24) isolierten und über dem Floating-Gate (24) liegenden Steuergate (26), und einen zweiten Transistor (30) umfaßt, dessen Source-(34) und Drainbereich (36) durch einen P-Kanal (38) getrennt sind, wobei der N-Kanal (20) durch das Floating-Gate (24) des ersten Transistors (12) gesteuert wird, das die folgenden Schritte umfaßt:

Anlegen einer Drain-Schreibspannung an den Drainbereich (16) des ersten Transistors (12);
Anlegen einer Steuergate-Schreibspanung an das Steuergate (26) des ersten Transistors (12);
Veranlassen eines Elektronenflusses vom Drainbereich (16) des ersten Transistors (12) zum Floating-Gate (24) mittels Fowler-Nordheim-Tunnelung als Reaktion auf die Schritte für das Anlegen der Schreibspannungen;
Anlegen des Drainbereiches (36) des zweiten Transistors (30) an Masse;
Versetzen des Sourcebereichs (34) des zweiten Transistors (30) in den Floating-Zustand;

Anlegen einer Vorspannung an den Kanal (38) des zweiten Transistors (30), um eine Voreinstellung der Schwellenspannung vorzunehmen;

Überwachen des Potentials des Sourcebereichs (34) des zweiten Transistors (30); und

Stoppen des Anlegens der Schreibspannung an das Steuergate (26) des ersten Transistors (12) als Reaktion auf den Überwachungsschritt, wenn die Spannung an dem Sourcebereich (34) des zweiten Transistors (12) abnimmt.

17. Verfahren nach Anspruch 16, bei dem der Schritt des Anlegens einer Vorspannung an den Kanal (38) des zweiten Transistors (30) das Anlegen einer positiven Spannung umfaßt, um die Schwellenspannung der Zelle zu erhöhen.

18. Verfahren nach Anspruch 17, bei dem die positive Spannung an eine Wanne (32) angelegt wird, die in dem Substrat gebildet ist und in der der zweite Transistor (30) gebildet ist.

19. Verfahren nach Anspruch 18, bei dem die an die Wanne (32) angelegte Spannung der Gate-Schreibspannung minus der gewünschten Änderung der Schwellenspannung der Zelle (10) entspricht.

## Revendications

1. Cellule de mémoire (10) morte électriquement effaçable, électriquement programmable (EEPROM) formée dans une couche de semiconducteur d'un premier type de conductivité et comportant un circuit pour la commande de la tension de seuil de la cellule de mémoire (10), la cellule de mémoire (10) comprenant:

un premier transistor (12) formé dans la couche de semiconducteur et ayant un région de source (14) et une région de drain (16) d'un deuxième type de conductivité, lesdites régions de source et de drain (14,16) étant séparées par une région de canal (20);

un deuxième transistor (30) formé dans la couche de semiconducteur et ayant une région de source (34) et une région de drain (36) du premier type de conductivité, lesdites régions de source et de drain (34,36) étant séparées par une région de canal (38), la région de drain (36) du deuxième transistor (30) étant connectée à une borne de mise à la masse;

une grille flottante (24) ayant une première partie adjacente à la région de canal (20) du premier transistor (12) et isolée de celle-ci et une deuxième partie adjacente à la région de canal (38) du deuxième transistor (30) et isolée de celle-ci;

une grille de commande (26) disposée adjacente à la grille flottante (24) et isolée de celle-ci; et

caractérisée en ce que la cellule de mémoire (10) comporte en outre:

une région de stockage (32) du deuxième type de conductivité formé dans la couche de semiconducteur de sorte qu'elle est espacée du premier transistor (12), le deuxième transistor (30) étant situé dans la région de stockage (32);

un circuit de commande de seuil (76) étant couplé à la région de stockage (32) et susceptible d'être actionné pour polariser la région de stockage (32) jusqu'à un potentiel de seuil prédéterminé par rapport à la grille de commande (26) de sorte que la cellule (10) est commandée de façon automatique;

un circuit de surveillance (58) sensible à une modification de potentiel dans la région de source (34) du deuxième transistor (30) pour commander l'application d'un potentiel sur la grille de commande (26) de sorte que la charge de la grille flottante (24) arrête d'augmenter lorsqu'un potentiel de seuil sélectionné est obtenu.

2. Cellule de mémoire selon la revendication 1, dans laquelle la cellule de mémoire (10) comporte un circuit actionnable au cours d'un cycle d'effacement pour commander la décharge de la grille flottante comprenant:

un circuit de commande de tension de drain (44) actionnable pour appliquer un potentiel à la région de drain (16) du premier transistor (12);

un circuit de surveillance d'effacement (52) pour surveiller le potentiel de la région de source (14) du premier transistor (12), le premier circuit de surveillance (52) étant sensible à une modification du potentiel de la région de source (14) du premier transistor pour stopper l'application d'un potentiel par le circuit de commande de tension de drain (42) à la région de drain (16) du premier transistor (12).

3. Cellule de mémoire selon la revendication 2, comportant en outre:

un circuit de contrôle de tension de grille (62) actionnable pour appliquer un potentiel à la grille de commande (26); et

dans lequel le circuit de surveillance (58) est couplé au circuit de commande de tension de grille (62) pour la surveillance du potentiel de la région de source (34) du deuxième transistor (30) par rapport à la région de stockage (32), le circuit de surveillance (58) étant sensible à une modification du potentiel de la région de source (34) par rapport à la grille de commande (26) pour arrêter l'application d'un potentiel à la grille de commande (26) par le circuit de commande de tension de grille (62).

4. Cellule de mémoire selon l'une quelconque des revendications 1 à 3, dans laquelle la région de drain (16) et la région de source (14) du premier transistor (12) sont formées à partir d'un matériau de type N, et la région de drain (36) et la région de source (34) du deuxième transistor (30) sont formées à partir d'un matériau de type P.

5. Cellule de mémoire selon l'une quelconque des revendications précédentes, comportant en outre une région épaisse d'oxyde formée de sorte qu'elle sépare le premier transistor (12) et le deuxième transistor (30).

6. Cellule de mémoire selon l'une quelconque des revendications précédentes, comportant en outre une fenêtre (22) à effet tunnel d'oxyde mince formée au-dessus de la région de canal (20) du premier transistor (12) et adjacente à la région de drain (16) de celui-ci.

7. Cellule de mémoire selon la revendication 6, dans laquelle la fenêtre (22) est une fenêtre à effet tunnel de type Fowler-Nordheim.

8. Cellule de mémoire selon la revendication 7, dans laquelle la grille de commande (26) est actionnable pour charger et décharger la grille flottante (24) par effet tunnel de type Fowier-Nordheim à travers ladite fenêtre à effet tunnel (22) par application d'un potentiel prédéterminé à la grille de commande (26) et à la région de drain (16) du premier transistor (12).

9. Cellule de mémoire selon l'une quelconque des revendications précédentes, dans laquelle la grille flottante (24) comporte une troisième partie ayant une zone de surface relativement large qui la couple de façon capacitive avec une partie coextensive de la grille de commande (26).

10. Cellule de mémoire selon l'une quelconque des revendications 5 à 9, dans laquelle la grille de commande (26) et la grille flottante (24) sont couplées dans une région recouvrant sensiblement la région d'oxyde épaisse.

11. Cellule de mémoire selon l'une quelconque des revendications précédentes, dans laquelle le circuit de surveillance (58) comporte un circuit amplificateur différentiel (90) qui est actionnable pour mesurer la différence de potentiel entre la région de stockage (32) et la région de source (34) du deuxième transistor (30).

12. Cellule de mémoire selon l'une quelconque des revendications précédentes, dans laquelle le circuit de commande de seuil (76) est actionnable pour polariser la région de stockage (32) à un potentiel égal au potentiel de la grille de commande (26) diminuée d'une modification prédéterminée du potentiel de seuil de la cellule de mémoire (10).

13. Cellule de mémoire selon l'une quelconque des revendications précédentes, comportant en outre des moyens couplés à la grille flottante (24) pour augmenter de façon incrémentielle une charge stockée dans la grille flottante (24) jusqu'à ce qu'un premier potentiel de seuil prédéterminé soit obtenu.

14. Cellule de mémoire selon l'une quelconque des revendications précédentes dans laquelle, comportant en outre des moyens couplés à la grille flottante (24) pour diminuer de façon incrémentielle une charge stockée dans la grille flottante (24) jusqu'à ce qu'un deuxième potentiel de seuil prédéterminé soit obtenu.

15. Cellule de mémoire selon l'une quelconque des revendications précédentes, dans laquelle le circuit de surveillance (58) est adapté pour détecter de façon différentielle la différence entre la région de stockage (32) et la région de source (34) du deuxième transistor (30).

16. Procédé de réglage de la tension de seuil d'une cellule de mémoire (10) morte électriquement effaçable, électriquement programmable, comprenant un premier transistor (12) ayant une source (14) et un drain (16) séparés par un canal de type N (20), une grille flottante (24) recouvrant le canal (20) et isolée de celui-ci, une fenêtre (22) à effet tunnel disposée dans le canal (20) adjacente au drain (16), et une grille de commande (26) recouvrant la grille flottante (24) et isolée de celle-ci, et un deuxième transistor (30) ayant une source (34) et un drain (36) séparés par un canal de type P (38), le canal de type N (20) étant commandé par la grille flottante (24) du premier transistor (12), comprenant les étapes consistant à:

appliquer une tension d'écriture de drain au drain (16) du premier transistor (12);
appliquer une tension d'écriture de grille de commande à la grille de commande (26) du premier transistor (12);
en réponse auxdites étapes d'application de tension d'écriture, provoquer la circulation d'électrons du drain (16) du premier transistor (12) vers la grille flottante (24) par effet tunnel de type Fowler-Nordheim;
mettre à la masse le drain (36) du deuxième transistor (30);
autoriser la source (34) du deuxième transistor (30) à flotter;
polariser le canal (38) du deuxième transistor (30) pour présélectionner la tension de seuil;
surveiller le potentiel de la source (34) du deuxième transistor (30); et
en réponse à ladite étape de surveillance, arrêter l'application de la tension d'écriture à la grille de commande (26) du premier transistor (12) lorsque la tension sur la source (34) du deuxième transistor diminue.

17. Procédé selon la revendication 16, dans lequel ladite étape de polarisation du canal (38) du deuxième transistor (30) comporte l'application d'une tension positive pour augmenter la tension de seuil de la cellule.

18. Procédé selon la revendication 17, dans lequel la tension positive est appliquée à une région de stockage (32) formée dans un substrat et dans laquelle le deuxième transistor (30) est formé.

19. Procédé selon la revendication 18, dans lequel la tension appliquée à la la région de stockage (32) est égale à la tension d'écriture de grille moins la modification désirée dans la tension de seuil de la cellule (10).

FIG. 1

EP 0 463 378 B1

GATE VOLTAGE (Vg)

ΔVr

DRAIN VOLTAGE

Vref

FIG. 2

FIG. 3

FIG. 4

FIG. 5

FIG. 6

FIG. 7